# EUROPÄISCHE PATENTSCHRIFT

(11) **EP 1 116 334 B1**
(45) Veröffentlichungstag und Bekanntmachung des Hinweises auf die Patenterteilung: **26.03.2003**
(21) Anmeldenummer: 99945852.4
(22) Anmeldetag: 01.07.1999
(51) Int. Cl.: H03M 13/00

(54) **VERFAHREN ZUR GEMEINSAMEN QUELLEN- UND KANALCODIERUNG**
METHOD FOR COMMON SOURCE AND CHANNEL CODING
PROCEDE POUR LE CODAGE COMMUN DE SOURCE ET DE CANAL

(30) Priorität: 24.09.1998 DE 19843981
(43) Veröffentlichungstag der Anmeldung: 18.07.2001
(73) Patentinhaber: SIEMENS AKTIENGESELLSCHAFT, 80333 München (DE)
(72) Erfinder: XU, Wen, D-82008 Unterhaching (DE)
(86) Internationale Anmeldenummer: DE9901993
(87) Internationale Veröffentlichungsnummer: WO00018015

(56) Entgegenhaltungen:
- HAGENAUER J: "SOURCE-CONTROLLED CHANNEL DECODING" IEEE TRANSACTIONS ON COMMUNICATIONS,US,IEEE INC. NEW YORK, Bd. 43, Nr. 9, Seite 2449-2457 XP000525669 ISSN: 0090-6778 in der Anmeldung erwähnt
- RUSCITTO A ET AL: "CHANNEL DECODING USING RESIDUAL INTRA-FRAME CORRELATION IN A GSM SYSTEM" ELECTRONICS LETTERS,GB,IEE STEVENAGE, Bd. 33, Nr. 21, Seite 1754-1755 XP000752306 ISSN: 0013-5194

## Beschreibung

Die vorliegende Erfindung bezieht sich auf ein Verfahren zur Codierung und Decodierung von Informationen, insbesondere zur digitalen Übertragung oder Speicherung.

Quellensignale bzw. Quelleninformationen wie Sprach-, Ton-, Bild- und Videosignale beinhalten fast immer statistische Redundanz, also redundante Informationen. Durch eine Quellencodierung kann diese Redundanz stark verringert werden, so daß eine effiziente Übertragung bzw. Speicherung des Quellensignals ermöglicht wird. Diese Redundanzreduktion beseitigt vor der Übertragung redundante Signalinhalte, die auf der Vorkenntnis von z.B. statistischen Parametern des Signalverlaufs beruhen. Nach der Übertragung werden bei der Quellendecodierung diese Anteile dem Signal wieder zugesetzt, so daß objektiv kein Qualitätsverlust nachweisbar ist.

Aufgrund der unvollständigen Kenntnisse über die Quellensignale oder Einschränkungen bei der Komplexität des Quellencodierverfahrens ist die Quellencodierung üblicherweise nur suboptimal realisierbar, d.h. in den komprimierten Daten ist auch nach der Quellencodierung noch eine gewisse Redundanz vorhanden. Bei bisherigen Verfahren zur Quellencodierung werden die Quellensignale häufig zu Symbolen oder quantisierten Parametern komprimiert, welche dann entsprechend einer Zuordnungsvorschrift auf binäre Codewörter abgebildet werden, wobei die Zuordnungsvorschrift bisher mehr oder weniger zufällig gewählt wurde.

Auf der anderen Seite ist es üblich, bei der Signalübertragung, gezielt Redundanz durch Kanalcodierung wieder hinzuzufügen, um die Beeinflussung der Übertragung durch Kanälstörungen weitgehend zu beseitigen. Durch zusätzliche redundante Bits wird es somit dem Empfänger bzw. Decoder ermöglicht, Fehler zu erkennen und eventuell auch zu korrigieren.

Lange Zeit war es eine der grundlegenden Prämissen der Informationstheorie, daß die Quellencodierung und die Kanalcodierung unabhängig voneinander ausgeführt werden können, um ein optimales Ergebnis zu erzielen. Gemäß dieser Grundlage hängt die Auslegung des Quellen-Decodierers nur von den Quelleneigenschaften ab, wohingegen das Kanalcodierungsschema nur von den Kanaleigenschaften abhängen soll. Dieser Grundsatz kann richtig sein, wenn der Quellen-Codierer statistisch unabhängige und somit nicht korrelierte sowie gleich wahrscheinliche Symbole liefert und die Decodierverzögerung beliebig groß werden kann. In der praktischen Anwendung sind indessen in der Regel diese Voraussetzungen nicht erfüllt. Das Ausgangssignal, des Quellen-Codierers, bzw. die von ihm ausgegebenen Symbolfolgen weisen oft eine Restredundanz auf, und gleichzeitig ist die erlaubte Verzögerung insbesondere bei Sprachübertragung beschränkt.

Es ist bekannt, diese Restredundanz der quellencodierten Symbolfolgen bei der sogenannten quellengesteuerten Kanaldecodierung auszunutzen. Dabei wird der Decodiervorgang des Kanaldecoders einerseits durch die übertragenen Bits und andererseits durch eine A-priori-/A-posteriori-Information über den wahrscheinlichsten Wert einiger wichtiger Quellenbits gesteuert. Die Quelleninformation hat also einen Einfluß auf das Ergebnis der Kanaldecodierung. Im Falle der Viterbi-Algorithmus-Decodierung wird dieses Verfahren als A-priori-Viterbialgorithmus bezeichnet. Bei Verwendung eines solchen Verfahrens ist eine Modifikation nur seitens des Empfängers notwendig. So lehrt die Druckschrift J. Hagenauer, "Source-controlled channel decoding", IEEE Trans. Commun., Band 43, Seiten 2449 - 2457, September 1995, bei der quellengesteuerten Kanaldecodierung die Inter-Rahmen-Korrelation, d.h. die statistische Abhängigkeit zwischen zeitlich und/oder örtlich benachbarten Signalsamples auszunutzen.

Untersuchungen haben auch ergeben, daß es - aufgrund der ungleichen Verteilung der Parameterwerte, die wiederum auf der Nichtstationarität der Quellensignale zurückzuführen ist - eine Restredundanz nicht nur zwischen Bits aufeinanderfolgender Rahmen, sondern auch zwischen den Bits eines Parameters innerhalb eines Rahmens gibt.

Die vorliegende Erfindung hat zur Aufgabe, eine Informationsübertragung oder Informationsspeicherung mit möglichst wenig Fehlern und möglichst geringem Aufwand zu erreichen.

Die oben genannte Aufgabe wird erfindungsgemäß durch die Merkmale der unabhängigen Ansprüche gelöst.

Die Erfindung beruht demnach auf dem Gedanken, die Symbole zunächst nach ihrer relativen Häufigkeit zu sortieren und dem Sortierergebnis den natural binary code zuzuordnen.

Durch die Erfindung wird erreicht, daß ohne Mehraufwand die Fehlerrate der decodierten Bits reduziert werden kann, und so Informationen mit weniger Störungen übertragen werden können.

Die Erfindung wird im folgenden anhand bevorzugter Ausführungsbeispiele näher beschrieben. Dabei wird besonders die digitale Übertragung der Informationen beschrieben. Dennoch ist die Erfindung auch zur Speicherung von Informationen anwendbar, da das Schreiben von Informationen auf ein Speichermedium und das Lesen von Informationen von einem Speichermedium hinsichtlich der vorliegenden Erfindung dem Senden von Informationen und dem Empfangen von Informationen entspricht.

Oft wird der Begriff "Decodierung" verwendet, um die Decodierung kanalcodierter Bitstellen zu beschreiben, während der Begriff "Detektion" verwendet wird, wenn allgemein über die binären Werte einer Bitstelle entschieden wird. Da die vorliegende Erfindung auf beide Fälle vorteilhaft anwendbar ist, beinhaltet im Rahmen der vorliegenden Patentanmeldung der Begriff "Decodierung" auch den Vorgang der Detektion.

Zur Erläuterung der Ausführungsformen der Erfindung dienen die nachstehend aufgelisteten Figuren.

### Es zeigen:

Figur 1 eine schematische Darstellung einer Nachrichtenübertragungskette
Figur 2 eine schematische Darstellung des Zusammenhangs zwischen Symbolen und den quellencodierten Bitfolgen in einer Rahmenstruktur
Figur 3 Häufigkeitsverteilung der Symbole und der binären Werte je nach binärer Abbildung

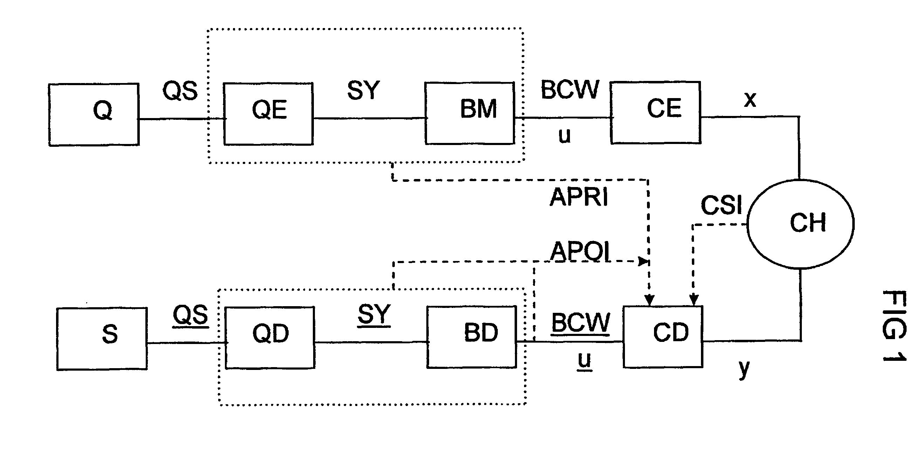

Figur 1 zeigt eine Quelle Q, die Quellensignale QS erzeugt, die von einem Quellencodierer QE, wie dem GSM fullrate Sprachcodierer, zu aus Symbolen bestehenden Symbolfolgen SY komprimiert werden. Die Symbole haben dabei einen der Werte c,j (Symbolwert) . Bei parametrischen Quellcodierverfahren werden die von der Quelle Q erzeugten Quellensignale QS (z.B. Sprache) in Blöcke unterteilt (z.B. zeitliche Rahmen) und diese getrennt verarbeitet. Der Quellencodierer QE erzeugt quantisierte Parameter (z.B. Sprachkoeffizienten), die im folgenden auch als Symbole einer Symbolfolge SY bezeichnet werden, und die die Eigenschaften der Quelle im aktuellen Block auf eine gewisse Weise widerspiegeln (z.B. Spektrum der Sprache, Filterparameter). Diese Symbole weisen nach der Quantisierung einen bestimmten Symbolwert c,j auf.

So erzeugt beispielsweise der GSM-Fullratecoder 76 Parameter, von denen die Parameter 0 bis 7 die sogenannten LAR-Koeffizienten (logarithmical area ratio) sind, die bei der LPC-Analyse erzeugt werden (linear prediction coding). Die Parameter Nr. 9, 26, 43 und 60 sind Ähnlichkeitsmaße für die sogenannte LTP (long term prediction).In jedem Rahmen gibt es außerdem vier XMAX-Koeffizienten (bzw. -Parameter) aus der sogenannten RPE-Analyse (regular pulse exciting), die sich von Rahmen zu Rahmen nur wenig ändern.

Aufgrund der unvollständigen Kenntnisse über die Quellensignale oder Einschränkungen bei der Komplexität des Quellencodierverfahrens ist die Quellencodierung QE üblicherweise nur suboptimal realisierbar, d.h. in den komprimierte Informationenen enthaltenden Symbolfolgen SY ist noch redundante Information enthalten.

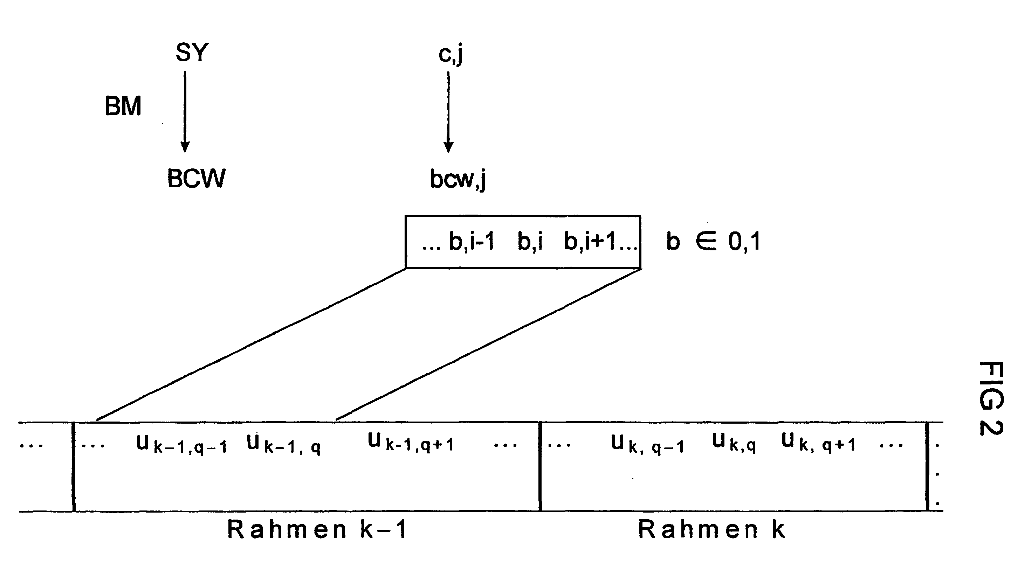

Die Symbole der Symbolfolge SY bzw. die entsprechenden Symbolwerte c,j werden wie in Figur 2 gezeigt durch eine binäre Abbildung BM (Zuordnungsvorschrift), die häufig als Teil der Quellencodierung QE beschrieben wird, auf eine Folge BCW binärer Codewörter bcw,j abgebildet, die jeweils mehrere Bitstellen b,i aufweisen. Es wird also jedem Symbolwert c,j ein anderes binäres Codewort bcw,j zugeordnet, die sich durch unterschiedliche binäre Werte an einer oder mehreren Bitstellen b,i unterscheiden. Dabei kennzeichnet der Index j die unterschiedlichen Werte der Symbole oder die unterschiedlichen Codewörter und die Indices i und im folgenden k,q die Stelle an der ein entsprechender Wert steht.

Werden diese binären Codewörter bcw,j beispielsweise nacheinander als Folge BCW binärer Codewörter weiterverarbeitet, so entsteht eine Folge u von quellencodierten Bitstellen uq, die in einer Rahmenstruktur eingebettet sein können, wobei jede Bitstelle u_{q} fest einer bestimmten Bitstelle b,i eines bestimmten Codewortes bcw,j zugeordnet ist. So entsteht beispielsweise bei der GSM-Fullratecodierung alle 20 Millisekunden ein Rahmen mit 260 Bitstellen u_{q}.

Figur 2 zeigt eine so entstehende Rahmenstruktur eines Rahmens k. Die quellencodierten Bitstellen u_{q} haben entweder den Wert "+1" oder "-1" bzw. "0". Der Index 1 läuft innerhalb eines Rahmens von 0 bis Q-1, wobei Q die Anzahl von quellencodierten Bitstellen uq in einem Rahmen ist. In jedem Rahmen können die Bitstellen beispielsweise in drei Klassen mit unterschiedlicher Bedeutung und Sensitivität gegenüber Kanalstörungen eingeteilt werden.

In einem Kanalcodierer CE, wie einem Faltungscodierer, erfolgt eine Codierung der quellencodierten Bitfolgen u gegen Kanalstörungen derart, daß die geringste Bit-Fehler-Wahrscheinlichkeit in der wichtigsten Klasse auftritt. Dazu werden zuerst die 50 wichtigsten Bits (Klasse 1a) durch 3 Bits einer zyklischen Blocksicherheit (CRC) gesichert. Die nächsten 132 wichtigen Bits (Klasse 1b) werden mit den zuvor genannten 53 Bits regruppiert und zusammen mit 4 Tail-Bits mit einer Rate 1/2 faltungscodiert. Die 78 weniger wichtigen Bits (Klasse 2) werden uncodiert übertragen.

Diese derart kanalcodierten Bitfolgen x werden in einem nicht dargestellten Modulator weiterverarbeitet und anschließend über eine Übertragungsstrecke CH übertragen. Bei der Übertragung treten Störungen auf, z.B. Fading, beschrieben durch einen Fadingfaktor ak, und Rauschen, beschrieben durch den Rauschfaktor NO.

Die Übertragungsstrecke CH liegt zwischen einem Sender und einem Empfänger. Der Empfänger enthält gegebenenfalls eine nicht dargestellte Antenne zum Empfang der über die Übertragungsstrecke CH übertragenen Signale, eine Abtasteinrichtung, einen Demodulator zum Demodulieren der Signale und einen Entzerrer zum Eliminieren der Intersymbolstörungen. Diese Einrichtungen wurden ebenfalls aus Vereinfachungsgründen in Figur 1 nicht dargestellt. Auch ein mögliches Interleaving und Deinterleaving ist nicht dargestellt.

Der Entzerrer gibt Empfangswerte einer Empfangsfolge y aus. Die Empfangswerte haben aufgrund der Störungen bei der Übertragung über die Übertragungsstrecke CH Werte, die von "+1" und "-1" abweichen, z.B. "+0,2" oder "-3,7".

In einem Kanaldecodierer CD wird die Kanalcodierung rückgängig gemacht. Dazu wird auf der Basis der Empfangswerte der Empfangsfolge y über die binären Werte der einzelnen empfangenen Bitstellen u_{q} bzw. b,i entschieden. Neben den Kanalzustandsinformationen CSI kann dabei die oben erklärte Restredundanz der Symbolfolgen SY bei der sogenannten quellengesteuerten oder gemeinsamen Kanaldecodierung CD ausgenutzt werden, um Bitfehler zu korrigieren bzw. die Decodierung zu verbessern. Hierzu gibt es prinzipiell zwei Möglichkeiten:
- Im Sinne einer A-Priori-Information APRI wird die redundante Information über die Häufigkeit der Symbolwerte c,j und somit auch der Häufigkeit der binären Werte bestimmter Bitstellen b,i und die Korrelation der Symbole untereinander und somit auch der Korrelation der binären Werte bestimmter Bitstellen b,i untereinander im Kanaldecodierer CD direkt genutzt, indem beispielsweise diese Information zuvor in einem Testquellcodierer bzw. mittels eines Testquellcodierers durch einige Testquellsignale ermittelt wird, und dann diese Information in einer dem Kanaldecodierer CD zugeordneten Speichereinheit abgespeichert wird und zur Kanaldecodierung ausgenützt wird, indem sie beispielsweise zur Bestimmung einer Schwelle, ab der beispielsweise für einen Wert der Empfangsfolge y auf den binären Wert "1" entschieden wird, verwendet wird.
- Die redundante Information über die Häufigkeit der Symbolwerte c,j und somit auch der Häufigkeit der binären Werte bestimmter Bitstellen b,i und die Korrelation der Symbole untereinander und somit auch der Korrelation der binären Werte bestimmter Bitstellen b,i untereinander wird im Sinne einer A-Posteriori-Information nach der Kanaladecodierung CD ermittelt. Die A-Posteriori-Information APOI kann dabei direkt nachdem Kanaldecodierer CD oder nach der bzw. während der Quellendecodierung QD ermittelt werden.

Ein derartiges Verfahren ist in "J. Hagenauer, "Source-controlled channel decoding," IEEE Tran. Commun., vol. 43, pp. 2449-2457, Sept. 1995", insbesondere auf den Seiten 2451 und 2452 beschrieben, wobei der Decodiervorgang des Kanaldecoders sowohl durch die übertragenen Codebits als auch durch eine A-Priori-/A-Posteriori-Information über den wahrscheinlichen Wert einiger wichtiger Quellenbits gesteuert wird. Im Falle der VA-(Viterbi-Algorithmus) Decodierung wurde diese Methode als Apri-VA bezeichnet.

Zur Kanaldecodierung CD kann beispielsweise auch ein SOVA (Weichausgangs (Soft-Output)-Viterbi-Algorithmus) verwendet werden. Ein SOVA ist dabei ein Algorithmus, der nicht nur einen Entscheidungswert ausgibt, sondern weiterhin auch angibt, mit welcher Wahrscheinlichkeit der entschiedene Wert vorliegt.

Nach erfolgter Kanaldecodierung CD erfolgt eine Rückabbildung DB der empfangenen kanaldecodierten Bitfolgen u bzw. der darin enthaltenen binären Codewörter bcw,j auf empfangene Symbole von empfangenen Symbolfolgen SY, welche anschließend bei der Quellendecodierung QD in empfangene Quellensignale QS verarbeitet werden und an der Informationssinke S ausgegeben werden.

Im folgenden werden 4 mögliche unterschiedliche binäre Abbildungen BM vorgestellt:
- Natural binary code NBC
- Folded binary code FBC
- Gray binary code GBC
- Minimum distance code MDC

Diese 4 binären Abbildungen sind in der folgenden Tabelle exemplarisch mit jeweils 4 Bitstellen dargestellt:

| Symbol | Codewort bcw,j NBC | | | | Codewort bcw,j FBC | | | | Codewort bcw,j GBC | | | | Codewort bcw,j MDC | | | |
|---|---|---|---|---|---|---|---|---|---|---|---|---|---|---|---|---|
| c,j | b3 | b2 | b1 | b0 | b3 | b2 | b1 | b0 | b3 | b2 | b1 | b0 | b3 | b2 | b1 | b0 |
| c0 | 0 | 0 | 0 | 0 | 0 | 1 | 1 | 1 | 0 | 0 | 0 | 0 | 0 | 1 | 1 | 1 |
| c1 | 0 | 0 | 0 | 1 | 0 | 1 | 1 | 0 | 0 | 0 | 0 | 1 | 0 | 1 | 1 | 0 |
| c2 | 0 | 0 | 1 | 0 | 0 | 1 | 0 | 1 | 0 | 0 | 1 | 1 | 0 | 1 | 0 | 1 |
| c3 | 0 | 0 | 1 | 1 | 0 | 1 | 0 | 0 | 0 | 0 | 1 | 0 | 0 | 0 | 1 | 1 |
| c4 | 0 | 1 | 0 | 0 | 0 | 0 | 1 | 1 | 0 | 1 | 1 | 0 | 0 | 1 | 0 | 0 |
| c5 | 0 | 1 | 0 | 1 | 0 | 0 | 1 | 0 | 0 | 1 | 1 | 1 | 0 | 0 | 1 | 0 |
| c6 | 0 | 1 | 1 | 0 | 0 | 0 | 0 | 1 | 0 | 1 | 0 | 1 | 0 | 0 | 0 | 1 |
| c7 | 0 | 1 | 1 | 1 | 0 | 0 | 0 | 0 | 0 | 1 | 0 | 0 | 0 | 0 | 0 | 0 |
| c8 | 1 | 0 | 0 | 0 | 1 | 0 | 0 | 0 | 1 | 1 | 0 | 0 | 1 | 0 | 0 | 0 |
| c9 | 1 | 0 | 0 | 1 | 1 | 0 | 0 | 1 | 1 | 1 | 0 | 1 | 1 | 0 | 0 | 1 |
| c1 | 1 | 0 | 1 | 0 | 1 | 0 | 1 | 0 | 1 | 1 | 1 | 1 | 1 | 0 | 1 | 0 |
| c11 | 1 | 0 | 1 | 1 | 1 | 0 | 1 | 1 | 1 | 1 | 1 | 0 | 1 | 1 | 0 | 0 |
| c12 | 1 | 1 | 0 | 0 | 1 | 1 | 0 | 0 | 1 | 0 | 1 | 0 | 1 | 0 | 1 | 1 |
| c13 | 1 | 1 | 0 | 1 | 1 | 1 | 0 | 1 | 1 | 0 | 1 | 1 | 1 | 1 | 0 | 1 |
| c14 | 1 | 1 | 1 | 0 | 1 | 1 | 1 | 0 | 1 | 0 | 0 | 1 | 1 | 1 | 1 | 0 |
| c15 | 1 | 1 | 1 | 1 | 1 | 1 | 1 | 1 | 1 | 0 | 0 | 0 | 1 | 1 | 1 | 1 |
| # (Bitw echsel ) | 1 | 3 | 7 | 15 | 1 | 2 | 6 | 14 | 1 | 2 | 4 | 8 | 1 | 6 | 10 | 10 |

Bei bisher bekannten Verfahren zur Quellencodierung wurden die Symbole bzw. Parameter nach der Quellencodierung QE und Quellenquantisierung unsortiert auf den natural binary code NBC abgebildet. Die quellengesteuerte Kanaldecodierung CD wurde folglich auch nur auf derart quellencodierte Bitstellen b,i angewandt.

Wenn in den Symbolen bzw. den aus Symbolen bestehenden Symbolfolgen SY noch redundante Informationen vorhanden sind, d.h. die relativen Häufigkeiten der Symbolwerte c,j ungleich verteilt sind, oder einige Symbole miteinander korreliert sind, so existiert automatisch auch eine redundante Information in einigen Bitstellen b,i. Es stellte sich bei aufwendigen Simulationen mit eigens für diesen Zweck entwickelten Simulationsverfahren heraus, daß aufgrund der ungleichen Verteilung der Symbolwerte c,j durch die gezielte Verwendung bestimmter binärer Abbildungen BM die in den Symbolfolgen SY enthaltene Restredundanz bei der Kanaldecodierung CD besonders gut zur Verbesserung der Fehlerkorrektur ausgenützt werden kann.

Die vorliegende Erfindung nützt die in der Symbolfolge SY vorhandene Restredundanz besonders gut zur Decodierung der binären Werte der Bitstellen bzw. der Bitstellen b,i, indem nicht irgendeine zufällig gewählte Abbildung BM gewählt wird, sondern statt dessen zur binären Abbildung die Symbole bzw. Parameter zunächst nach ihrer Wahrscheinlichkeit sortiert werden und der so entstehenden Symbolstruktur der natural binary code zugeordnet wird.

So ist den nach ihrer Auftrittswahrscheinlichkeit sortierten Symbolen der natural binary code (NBC) in einer Weise zugeordnet ist, daß dem am häufigsten auftretenden Symbol ein Codewort zugeordnet ist, das an allen Bitstellen den ersten binären Wert aufweist bzw. ein Codewort zugeordnet ist, das an allen Bitstellen den zweiten binären Wert aufweist, unddem am seltensten auftretenden Symbol ein Codewort zugeordnet ist, das an allen Bitstellen den zweiten binären Wert aufweist bzw. ein Codewort zugeordnet ist, das an allen Bitstellen den ersten binären Wert aufweist.

Dies führt zu einer effizienten Abbildung der Symbolredundanz auf die individuelle Bitstellenredundanz; dadurch sind mehr redundante Informationen über die binären Werte der einzelnen Bitstellen b,i zur Fehlerkorrektur ausnutzbar. Außerdem ist zur Decodierung des most significant bit mehr redundante Information nutzbar als zur Decodierung des second most significant bits. Insbesondere zur Abbildung von digitalen Daten oder vektorquantisierten Parametern auf Codewörter können - wie Simulaionsergebnisse zeigen - durch ein erfindungsgemäßes Verfahren die Decodierungsergebnisse besonders verbessert werden.

Bei der quellengesteuerten Kanaldecodierung CD kann nun die in den quellencodierten Symbolfolgen SY vorhandene Restredundanz (ungleiche Verteilung) leichter und effizienter genutzt werden, da die in der Symbolebene vorhandene Redundanz dadurch in eine in der Bitebene vorhandene Redundanz (ungleiche Verteilung) umgewandelt wird, die vom quellengesteuerten Kanaldecoder (z.B. Apri-VA) direkt verwendet werden kann. Mit diesem Verfahren erzielt man eine verbesserte Qualität bei der Übertragung der Quellensignale QS(Ton, Sprache, etc.). Der zusätzliche Rechenaufwand für eine derartige Sortierung vor der binären Abbildung BM ist gering und kann üblicherweise vernachlässigt werden.

Eine solche binäre Abbildung BM kann implizit im Quellenencoder und -decoder integriert werden. Für bereits standardisierte Codecs wie GSM Fullrate/Enhanced Fullrate Sprachcodec bedeutet sie jedoch eine Modifizierung sowohl im Empfänger als auch im Sender. Allerdings ist diese Modifizierung ohne große Hardwareänderung möglich. Beim GSM System ist von der Infrastrukturseite nur eine Hinzufügung der binären Abbildung und inversen Abbildung in dem TRAU (transcoder and rate adaptor unit) nötig, die BTS (base transceiver station), BSC (base station controller), etc. bleiben unverändert.

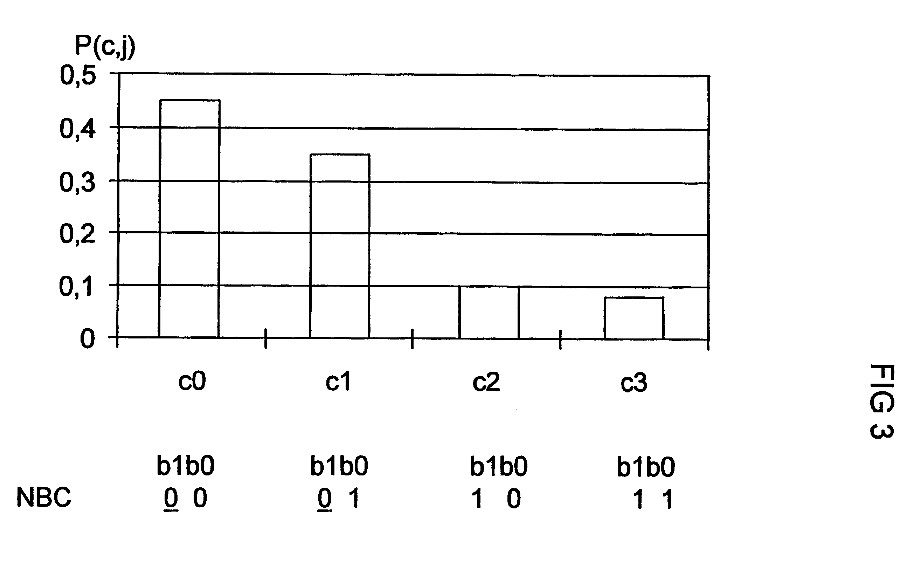

Figur 3 zeigt die Häufigkeitsverteilung der Symbolwerte c,j und die zugeordneten binären Codewörter bcw,j. Dabei ist zu sehen, daß im Falle des NBC an der ersten Bitstelle b1 die Wahrscheinlichkeit für den binären Wert "0" sehr viel größer ist als der für den binären Wert "1", insbesondere unter der Bedingung, daß das Symbol c1 oder c2 gesendet wurde. Diese Information kann bei der quellengesteuerten Kanaldecodierung im Sinne einer A-Posteriori oder A-Priori Information genützt werden, um über den binären Wert der Bitstelle b1 zu entscheiden, bzw. die dazu verwendete Schwelle zu bestimmen, und so die Entscheidung zuverlässiger zu machen.

Die Decodierung kann also noch verbessert werden, wenn auch eine Information über den wahrscheinlich übertragenen Symbolwert c,j verwendet wird.

Hätte man vor der binären Abbildung die Symbole nicht sortiert, so wäre die bei der quellengesteuerten Kanaldecodierung verwendete A-Posterioi oder A-Priori Information (d.h. die Wahrscheinlichkeit für den binären Wert "0") in der Regel kleiner und die Decodierung der Bitstellen könnte nicht so zuverlässig durchgeführt werden.

Bei einer Ausführungsvariante der Erfindung werden nach Sortierung und Abbildung von Symbolen auf Codewörter, alle oder ein Teil der Bitstellen von Codewörtern vertauscht.

Bei einer Ausgestaltung der Erfindung wird die aus Symbolfolgen SY bestehenden Information derart auf binäre Codewörter bcw,j mit jeweils einer Mehrzahl von Bitstellen b,i abgebildet, daß auch die Korrelation zwischen den binären Werten der entsprechenden Bitstellen b,i,k (oder in der Rahmenebene uq,k ) und b,i,k+1 (oder in der Rahmenebene uq,k+1 ) aufeinanderfolgender Rahmen k, k+1 groß ist. Dabei wird insbesondere eine Korrelation der Quellenbits berücksichtigt. Die grundlegende Idee dieses Verfahrens besteht dabei darin, daß sich entsprechende Symbole zwischen zwei aufeinanderfolgenden Rahmen nicht sehr oft ändern und somit eine Redundanz bei der Übertragung vorliegt. Diese Korrelation zwischen aufeinanderfolgenden Rahmen kann empfängerseitig unter Verwendung eines APRI-SOVA (A-priori-Weichausgangs-Viterbi-Algorithmus)-Decodierers besonders gut ausgenutzt werden, wenn eine binäre Abbildung BM derart gewählt wird, daß die Korrelation zwischen den binären Werten der entsprechenden Bitstellen aufeinanderfolgender Rahmen groß ist. So stellte sich bei aufwendigen Simulationen besonders die Verwendung des GBC als binäre Abbildung als besonders vorteilhaft heraus, insbesondere wenn die Symbole eine gaußsche oder eine anti-gaußsche Verteilung besitzen, was in vielen Fällen der Fall ist.

Bei quellengesteuerter Kanaldecodierung CD kann auch die Inter-Rahmen-Korrelation, d.h. die statistische Abhängigkeit zwischen zeitlich und/oder örtlich benachbarten Signalsamples genutzt werden. Zur Schätzung der A-Priori-/A-Posteriori-Information kann man beispielsweise den empirischen "HUK-Algorithmus", der in "J. Hagenauer, "Source-controlled channel decoding," IEEE Tran. Commun., vol. 43, pp. 2449-2457, Sept. 1995" beschrieben ist oder ein auf Kalman-Filter basierende Verfahren zur quellengesteuerten Kanaldecodierung verwenden.

Bei einer weiteren Ausführungsvariante werden die aus Symbolfolgen SY bestehenden Informationen derart auf binäre Codewörter bcw,j mit jeweils einer Mehrzahl von Bitstellen b,i abgebildet, daß bei einem falsch detektiertem binären Wert, der Fehler im detektierten Symbol bzw. dem ausgegebenen Quellensignal QS klein ist. Durch eine geeignete binäre Abbildung BM werden so die Quellensignale weniger empfindlich auf Kanalstörungen reagieren. So stellte sich bei aufwendigen Simulationen besonders die Verwendung des FBC als binäre Abbildung als besonders vorteilhaft heraus, insbesondere wenn die Symbole eine gaußsche oder eine anti-gaußsche Verteilung besitzen, was in vielen Fällen der Fall ist.

Es sind auch Ausführungsvarianten möglich, bei denen die binäre Abbildung BM so gewählt ist, daß mehrere Aspekte der oben beschriebenen Varianten im Sinne eines Kompromisses kombiniert werden.

Zur Durchführung der oben erklärten Verfahren ist ein, beispielsweise in einem Funkgerät, wie eine Mobilstation oder Basisstation eines Mobilfunksystems, integrierter, programmgesteuerter Signalprozessor vorgesehen, der zu übertragende Informationen nach einem der oben beschriebenen Verfahren codiert und/oder decodiert.

## Patentansprüche

1. Verfahren zur Codierung von aus einer Quellencodierung (QE) hervorgehenden Symbolfolgen (SY), wobei Symbole mit unterschiedlichen Wahrscheinlichkeiten auftreten,
- bei dem Symbole auf einer Kanalcodierung zuzuführende binäre Codewörter (bcw,j) mit jeweils einer Mehrzahl von Bitstellen (b,i) abgebildet werden,
- wobei die Abbildung derart erfolgt, daß nach ihrer Auftrittswahrscheinlichkeit sortierten Symbolen der natural binary code (NBC) zugeordnet ist.

2. Verfahren nach Anspruch 1, bei dem
- zumindest ein wesentlicher Anteil der Symbole oder alle Symbole nach ihrer Wahrscheinlichkeit sortiert werden, und
- zumindest einem wesentlichen Anteil der derart sortierten Symbole oder allen derart sortierten Symbolen oder allen Symbolen der natural binary code (NBC) zugeordnet ist.

3. Verfahren nach einem der vorhergehenden Ansprüche, bei dem
nach ihrer Auftrittswahrscheinlichkeit sortierten Symbolen der natural binary code (NBC) in einer Weise zugeordnet ist, daß
- dem am häufigsten auftretenden Symbol ein Codewort zugeordnet ist, das an allen Bitstellen den ersten binären Wert aufweist bzw. ein Codewort zugeordnet ist, das an allen Bitstellen den zweiten binären Wert aufweist, und
- dem am seltensten auftretenden Symbol ein Codewort zugeordnet ist, das an allen Bitstellen den zweiten binären Wert aufweist bzw. ein Codewort zugeordnet ist, das an allen Bitstellen den ersten binären Wert aufweist.

4. Verfahren nach einem der vorhergehenden Ansprüche, bei dem
Bitstellen (b,i) von aus der Abbildung resultierenden Codewörtern (bcw,j) vertauscht werden.

5. Signalprozessor zur Codierung von aus einer Quellencodierung (QE) hervorgehenden Symbolfolgen (SY) zum Zweck der Kanalcodierung, wobei Symbole mit unterschiedlichen Wahrscheinlichkeiten auftreten, mit
- Mitteln zur Abbildung von Symbolen auf binäre Codewörter (bcw,j) mit jeweils einer Mehrzahl von Bitstellen (b,i) derart, daß nach ihrer Auftrittswahrscheinlichkeit sortierten Symbolen der natural binary code (NBC) zugeordnet ist.

6. Funkstation mit einem Signalprozessor nach Anspruch 5.

## Claims

1. Method for coding symbol sequences (SY) provided by source coding (QE), in which symbols occur with different probabilities,
- in which symbols are mapped to binary code words (bcw,j), to be supplied to a channel coding, having in each case a plurality of bit positions (b,i),
- the mapping being done in such a manner that the natural binary code (NBC) is allocated to symbols sorted in accordance with their probability of occurrence.

2. Method according to Claim 1, in which
- at least a significant proportion of the symbols or all symbols are sorted in accordance with their probability, and
- the natural binary code (NBC) is allocated to at least a significant proportion of the symbols sorted in this manner or to all symbols sorted in this manner or to all symbols.

3. Method according to one of the preceding claims, in which the natural binary code (NBC) is allocated to symbols sorted in accordance with their probability of occurrence, in such a manner that
- a code word which has the first binary value at all bit positions or a code word which has the second binary value at all bit positions is allocated to the symbol occurring most frequently, and
- a code word which has the second binary value at all bit positions or a code word which has the first binary value at all bit positions is allocated to the symbol occurring most rarely.

4. Method according to one of the preceding claims, in which bit positions (b,i) of code words (bcw,j) resulting from the mapping are exchanged.

5. Signal processor for coding symbol sequences (SY) provided by a source coding (QE) for the purpose of channel coding, in which symbols occur with different probabilities, comprising
- means for mapping symbols to binary code words (bcw,j) with in each case a plurality of bit positions (b,i), in such a way that the natural binary code (NBC) is allocated to symbols sorted in accordance with their probability of occurrence.

6. Radio station comprising a signal processor according to Claim 5.

## Revendications

1. Procédé de codage de successions de symboles (SY) provenant d'un codage de sources (QE), les symboles apparaissant à différentes probabilités,
- dans lequel des symboles sont représentés par des mots binaires de codes (bcw,j) qui sont amenés à un codage canal et qui contiennent chacun une pluralité d'emplacements de bits (b,i),
- la représentation s'effectuant en associant le code binaire naturel (NBC) aux symboles triés en fonction de leur probabilité d'apparition.

2. Procédé selon la revendication 1, dans lequel
- au moins une partie essentielle des symboles ou tous les symboles sont triés en fonction de leurs probabilités, et
- le code binaire naturel (NBC) est associé à au moins une partie essentielle du symbole ainsi trié ou à tous les symboles ainsi triés ou à tous les symboles.

3. Procédé selon l'une des revendications précédentes, dans lequel le code binaire naturel (NBC) est associé aux symboles triés en fonction de leur probabilité d'apparition de telle sorte que:
- un mot de code qui présente la première valeur binaire sur tous les emplacements de bits resp. un mot de code qui présente la deuxième valeur binaire sur tous les emplacements de bits est associé aux symboles apparaissant le plus fréquemment, et
- un mot de code qui présente la deuxième valeur binaire sur tous les emplacements de bits resp. un mot de code qui présente la première valeur binaire sur tous les emplacements de bits est associé au symbole qui apparaît le plus rarement.

4. Procédé selon l'une des revendications précédentes, dans lequel
les emplacements de bits (b,i) des mots de code (bcw,j) qui résultent de la représentation sont permutés.

5. Processeurs de signaux pour le codage de successions de symboles (SY) provenant d'un codage de sources (QE), en vue du codage canal, les symboles apparaissant à différentes probabilités, comprenant:
- des moyens pour représenter des symboles en mots binaires de codes (bcw,j) qui présentent chacun une pluralité d'emplacements de bits (b,i) de telle sorte que le code binaire naturel (NBC) soit associé aux symboles triés en fonction de leur probabilité.

6. Poste radio présentant un processeur de signal selon la revendication 5.
